# EUROPÄISCHE PATENTSCHRIFT

(11) **EP 1 568 158 B1**
(45) Veröffentlichungstag und Bekanntmachung des Hinweises auf die Patenterteilung: **23.08.2006**
(21) Anmeldenummer: 02794978.3
(22) Anmeldetag: 04.12.2002
(51) Int. Cl.: H04B 10/24, G02B 6/42

(54) **BIDIREKTIONALES SENDE- UND EMPFANGSMODUL**
BIDIRECTIONAL EMITTING AND RECEIVING MODULE
MODULE D'EMISSION ET DE RECEPTION BIDIRECTIONNEL

(43) Veröffentlichungstag der Anmeldung: 31.08.2005
(73) Patentinhaber: Infineon Technologies AG, 81669 München (DE)
(72) Erfinder: WEIGERT, Martin, 14057 Berlin (DE); BACHL, Bernhard, 14612 Falkensee (DE)
(74) Vertreter: Müller, Wolfram Hubertus
(86) Internationale Anmeldenummer: PCT/DE2002/004492
(87) Internationale Veröffentlichungsnummer: WO 2004/051894

(56) Entgegenhaltungen:
- EP-A- 0 664 585
- WO-A-01/53868
- US-A- 5 577 142
- US-A- 6 097 521
- US-A1- 2001 012 767

## Beschreibung

Die Erfindung betrifft ein bidirektionales Sende- und Empfangsmodul, das Licht einer ersten Wellenlänge aussendet und Licht einer zweiten Wellenlänge detektiert. Ein bevorzugten Einsatzgebiet sind WDM (Wavelength Division Multiplex) Anwendungen.

Bidirektionale Sende- und Empfangsmodule sind an sich bekannt: Die bekannten Lösungen weisen den Nachteil auf, dass die Sendebauelemente und Empfangsbauelemente der Module jeweils auf getrennten Trägern und/oder mit getrennten Gehäusen realisiert sind.

Aus der EP 0 664 585 A1 ist ein Sende- und Empfangsmodul für die bidirektionale optische Nachrichten- und Signalübertragung bekannt. Dabei ist ein Laserchip auf einem Träger derart angeordnet, dass er Strahlung auf eine schrägverlaufende Grenzfläche eines auf dem Träger angeordneten Zusatzkörpers emittiert. Die emittierte Strahlung wird an der Grenzfläche umgelenkt, durch eine über dem Laserchip und der Grenzfläche angebrachte Linsenkoppeloptik geführt und in eine Glasfaser eingekoppelt. Unterhalb des Trägers ist in einer TO-Gehäusebodenplatte ein Fotodetektor angeordnet, der aus der Glasfaser austretende Strahlung detektiert, die über die Linsenkoppeloptik auf die Grenzfläche geleitet wird und durch diese und den Träger hindurch tritt.

Aus der US 5,577,142 ist ein sendendes und empfangendes Kommunikationsmittel für optische Fasern bekannt. Das Kommunikationsmittel weist insgesamt drei parallel übereinander angeordnete Träger auf, auf dessen obersten Träger eine Photodiode als Empfänger angeordnet ist. Eine Laserdiode als Sender und eine Monitordiode zum Messen eines Referenzsignals sind zwischen den drei Trägern integriert.

Der vorliegenden Erfindung liegt die Aufgabe zu Grunde, ein bidirektionales Sende- und Empfangsmodul zur Verfügung stellen, dass sich durch einen kompakten Aufbau und ein hohes Integrationsmaß auszeichnet.

Diese Aufgabe wird erfindungsgemäß durch ein Sende- und Empfangsmodul mit den Merkmalen des Anspruchs 1 gelöst. Bevorzugte und vorteilhafte Ausgestaltungen der Erfindung sind in den Unteransprüchen angegeben.

Danach weist das erfindungsgemäße Sende- und Empfangsmodul einen Träger auf, auf dessen Oberseite ein Sendebauelement und an dessen Unterseite ein Empfangsbauelement angeordnet sind. Der Träger ist dabei für das vom Empfangsbauelement zu detektierende Licht transparent. Es ist eine schräg verlaufende, mit einem wellenlängenselektiven Spiegel beschichtete Grenzfläche vorgesehen, an der zum einen vom Sendebauelement ausgesandtes Licht reflektiert und umgelenkt wird. Zum anderen wird an der schräg verlaufenden Grenzfläche vom Empfangsbauelement zu empfangendes Licht in das angrenzende Medium gebrochen. Das zu empfangende, an der Grenzfläche gebrochene Licht durchquert den Träger, tritt an der Unterseite des Trägers aus diesem aus und wird dann durch das Empfangsbauelement detektiert. Das Empfangsbauelement ist in einer Aussparung in der Unterseite des Trägers angeordnet. Die Aussparung ist tief genug, um das Empfangselement vollständig aufzunehmen.

Insbesondere ist die Aussparung so ausgelegt, das ein Empfangsbauelement mit einer Chipdicke von 80 µm bis 200 µm in der Aussparung montiert werden kann.

Die Aussparung wird beispielsweise durch einen Graben oder einen Pyramidenstumpf gebildet, der bevorzugt durch Ätzen in dem Träger ausgebildet ist. Grundsätzlich kann insbesondere ein Graben auch durch mechanische Verfahren wie Fräsen bereitgestellt werden.

Die erfindungsgemäße Lösung ist äußerst kompakt aufgebaut, da das Sendebaulement und das Empfangsbauelement auf nur einem Träger angeordnet sind. Dabei wird ein Strahlengang bereitgestellt, der ein Austreten des empfangenen Lichts auf der Rückseite des Trägers ermöglicht, so dass das Empfangsbaulelement dort angeordnet sein kann. Das Austreten des empfangenen Licht auf der Rückseite des Trägers, also das Vermeiden einer Totalreflexion wird durch ein möglichst senkrechtes Auftreffen des empfangenen Lichts auf die Unterseite des Trägers erreicht. Hierzu kann zum einen durch den Brechungsindex der verwendeten Materialen die Richtung der Lichtbrechung an der schräg verlaufenden Grenzfläche und damit die Richtung der Lichtausbreitung im Träger beeinflusst werden. Zum anderen können gegebenenfalls schräg verlaufende Aussparungen auf der Rückseite des Trägers vorgesehen sein.

Es wird darauf hingewiesen, dass die Anordnung des Empfangsbauelementes "an der Unterseite" des Trägers derart zu verstehen, dass das Empfangsbauelement direkt an der Unterseite des Trägers befestigt aber auch von der Unterseite beabstandet und lediglich unterhalb des Trägers angeordnet sein kann. Es muss kein physischer Kontakt zwischen Träger und Bauelement bestehen.

In einer bevorzugten Ausgestaltung der Erfindung weist das Modul einen Zusatzkörper auf, bei dem es sich bevorzugt um einen Glaskörper, insbesondere ein Glasprisma handelt. Der Zusatzkörper ist auf dem Träger angeordnet und bildet die schräg verlaufende Grenzfläche mit dem wellenselektiven Spiegel aus, wobei das zu empfangende, an der Grenzfläche gebrochene Licht zunächst den Zusatzkörper und dann den Träger durchquert. Der Zusatzkörper stellt dabei eine separat mit dem wellenlängenselektiven Spiegel beschichtbare Einheit dar.

In einer bevorzugten Ausführungsform ist dem Empfangsbauelement ein wellenlängenselektiver Filter zugeordnet, der sich an der Unterseite der Trägers befindet und die Transmission von Licht der ersten Wellenlänge blockiert. Der wellenlängen selektive Filter ist bevorzugt ein Hochpassfilter oder ein Tiefpassfilter, der Wellenlängen im Fenster von 1480 bis 1600 nm passieren läßt oder blockt.

In einer weiteren bevorzugten Ausgestaltung ist die Aussparung an der Unterseite des Trägers mit Metallisierungen versehen. Das Empfangsbauelement ist dabei in Flip-Chip Montage in der Aussparung montiert, wozu beide Kontakte auf einer Seite angeordnet sind. Die Flip-Chip Montage vermeidet die Verwendung eines Bonddrahtes, der nachteilig aus der Aussparung, in der das Empfangsbauelement angeordnet ist, herausragen würde.

In einer weiteren Erfindungsvariante ist die schräg verlaufende Grenzfläche nicht an einem Zusatzkörper, sondern an dem Träger selbst ausgebildet. Diese Ausgestaltung kommt somit ohne ein weiteres Teil aus, das mit dem Träger zu verbinden wäre. Vielmehr ist die schräg verlaufende Grenzfläche, an der das Licht des Sendebauelements reflektiert und das zu detektierende Licht in das angrenzende Medium gebrochen wird, in den Träger integriert.

Die schräg verlaufende Grenzfläche ist dabei bevorzugt an der Schräge einer Aussparung an der Oberseite des Trägers ausgebildet ist. Bevorzugt ist das Sendebauelement dann in der Aussparung angeordnet. Eine eine andere, gegenüberliegende Schräge der Aussparung kann als Strahlumlenkungseinheit für eine dem Sendebauelement zugeordnete Monitordiode dienen, die die rückseitige Strahlung der Laserdiode zu Überwachungszwecken erfaßt. Die Monitordiode ist dabei auf der obersten Ebene der Oberseite des Trägers angeordnet.

In einer Weiterbildung dieser Ausführungsvariante ist die Unterseite des Trägers derart in Bezug auf die Ausbreitungsrichtung des zu empfangenden Lichts im Träger orientiert, dass das zu empfangende Licht nach Durchqueren des Träger keine Totalreflexion an der Unterseite des Trägers erfährt und durch das Empfangsbauelement detektiert werden kann. Hierzu kann vorgesehen sein, dass der Träger auf seiner Unterseite eine Aussparung mit einer Schräge aufweist, aus der das zu empfangende Licht austritt.

Die Schräge kann dabei als Träger eines wellenlängenselektiven Filters dienen, der die Transmission von Licht der ersten Wellenlänge blockiert. Der wellenlängenselektive Filter kann entweder an der Schräge selbst oder an einem gesonderten Träger ausgebildet sein, der bevorzugt mittels eines indexangepassten, transparenten Klebers an der Schräge befestigt ist. Auch ist denkbar, dass Empfangsbauelement unmittelbar an der Schräge anzuordnen.

Die betrachtete Schräge der Aussparung an der Rückseite des Trägers verläuft bevorzugt parallel zu der schräg verlaufenden Grenzfläche mit dem wellenlängenselektiven Spiegel an der Oberseite des Trägers, wobei beide bevorzugt unter einem Winkel von 45° zur Montagefläche des Sendebauelements verlaufen. Es werden somit im Träger bevorzugt zwei parallele Ebenen erzeugt.

Zur Herstellung des Moduls kann vorgesehen sein, dass die Oberseite des Trägers aus einem ersten strukturierten Wafer und die Unterseite des Trägers aus einem zweiten strukturierten Wafer gebildet wird, die nach der Strukturierung mittels Waferfusing miteinander verbunden werden. Es wird dabei eine in der Nutzenmontage prüfbare Einheit gebildet, bei der ein Prüfen der Module vor einer Vereinzelung des Wafers erfolgt.

Der Träger besteht bevorzugt aus Silizium. Die schräg verlaufende Grenzfläche verläuft bevorzugt unter einem Winkel von 45° zur Ebene der Oberseite des Trägers, wobei die schräg verlaufende Grenzfläche entweder an einem Zusatzelement, insbesondere einem Glasprisma oder im Siliziumsubstrat selbst ausgebildet ist. Die jeweiligen Schrägen werden bevorzugt mikromechanisch durch Ätzen hergestellt.

Die Erfindung wird nachfolgend unter Bezugnahme auf die Figuren der Zeichnungen anhand mehrerer Ausführungsbeispiele näher erläutert. Es zeigen:
- Figur 1: eine Schnittansicht eines ersten Ausführungsbeispiels eines bidirektionalen Sende- und Empfangsmoduls;
- Figur 2: eine Schnittansicht eines Wafers zur Herstellung eines Sende- und Empfangsmoduls gemäß Figur 1;
- Figur 3: eine Schnittansicht des Sende- und Empfangsmoduls der Figur 1, wobei ausschließlich der Submount und das Glasprisma des Moduls sowie die daran angeordneten Schichten, Spiegel und Filter dargestellt sind;
- Figur 4: das Sende- und Empfangsmodul der Figur 3 in einer Ansicht von unten;
- Figur 5: das Sende- und Empfangsmodul der Figur 3 in einer Ansicht von oben;
- Figur 6: eine Gehäuseanordnung mit einem Sende- und Empfangsmodul gemäß den Figuren 1 bis 5;
- Figur 7: eine Schnittansicht eines alternativen Ausführungsbeispiels eines Sende- und Empfangsmoduls, wobei an einer Schräge an der Unterseite des Modulträgers ein Glas- oder Siliziumplättchen mit einem Blockingfilter angeordnet ist;
- Figur 8: ein Sende- und Empfangsmodul entsprechend dem Sende- und Empfangsmodul der Figur 7, wobei statt eines Glas- oder Siliziumplättchens mit einem Blockingfilter eine Blocking-Filterschicht direkt auf die Schräge an der Unterseite des Modulträgers aufgebracht ist;
- Figur 9: eine Schnittansicht eines Wafers zur Herstellung des Sende- und Empfangsmoduls der Figuren 7 und 8 und
- Figur 10: eine Gehäuseanordnung mit einem Sende- und Empfangsmodul gemäß den Figuren 7 und 8.

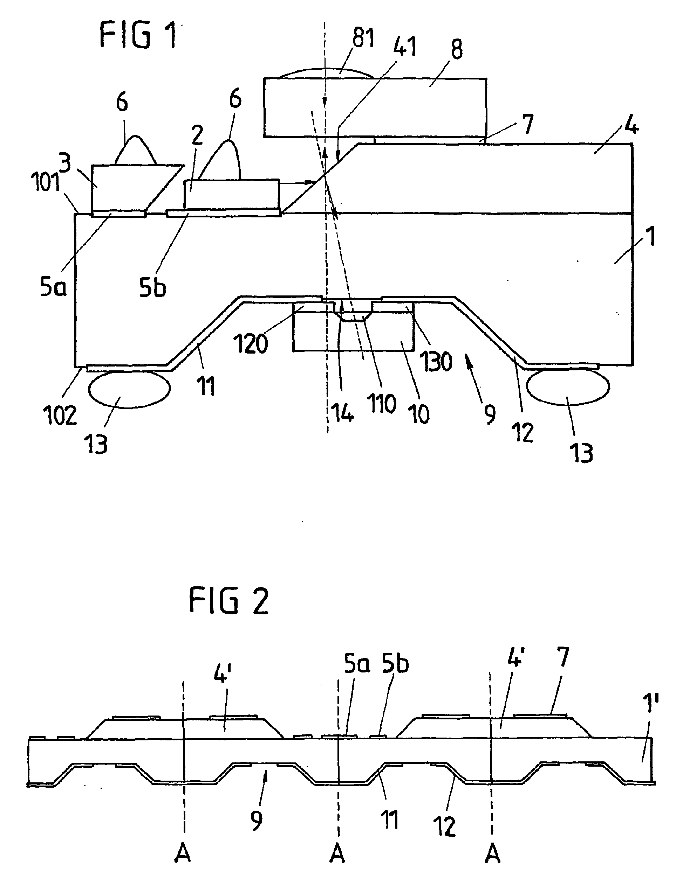

Die Figuren 1 bis 6 zeigen ein erstes Ausführungsbeispiel eines bidirektionalen Sende- und Empfangsmoduls. Wie insbesondere der Figur 1 zu entnehmen ist, weist das Sende- und Empfangsmodul einen Träger 1 auf, der nachfolgend auch als Submount bezeichnet wird und im dargestellten Ausführungsbeispiel aus Silizium besteht. Der Submount 1 weist eine Oberseite 101 und eine Unterseite 102 auf, die - abgesehen von in die jeweilige Oberfläche eingebrachten Aussparungen - parallel verlaufen.

Auf der Oberseite 101 des Submounts 1 sind eine Laserdiode 2, eine Monitordiode 3 und ein Glasprisma 4 angeordnet. Zur Kontaktierung der Laserdiode 2 und der Monitordiode 3 sind Metallisierungen 5a, 5b und Bonddrähte 6 vorgesehen. Die Laserdiode 2 ist als seitlich emittierender Laser ausgebildet. Ein geringer Prozentsatz des Laserlichtes wird dabei rückseitig ausgekoppelt und von der Monitordiode 3 zu Überwachungszwecken detektiert, wie an sich bekannt ist.

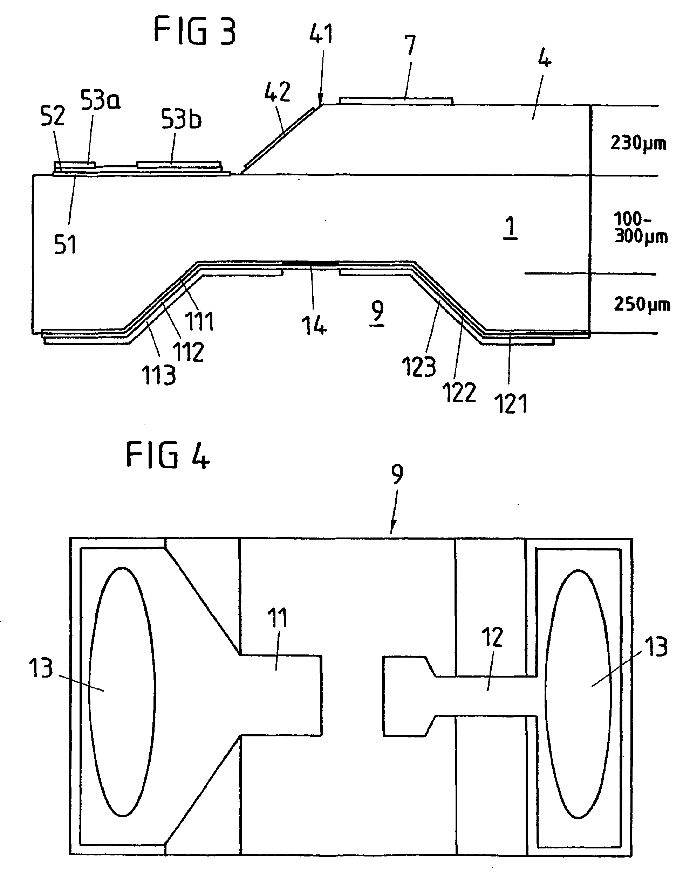

Das Glasprisma 4 weist eine unter einem Winkel von 45° verlaufende Grenzfläche 41 auf, die mit einem wellenlängenselektiven Spiegel 42 beschichtet ist (vgl. Fig. 3). Auf der Oberfläche des Glasprismas 4 ist mittels einer Metallisierung 7 ein Siliziumelement 8 befestigt, das eine geätzte Siliziumlinse 81 aufweist. Die Siliziumlinse 81 befindet sich dabei oberhalb der schräg verlaufenden Grenzfläche 41 des Glasprismas 4.

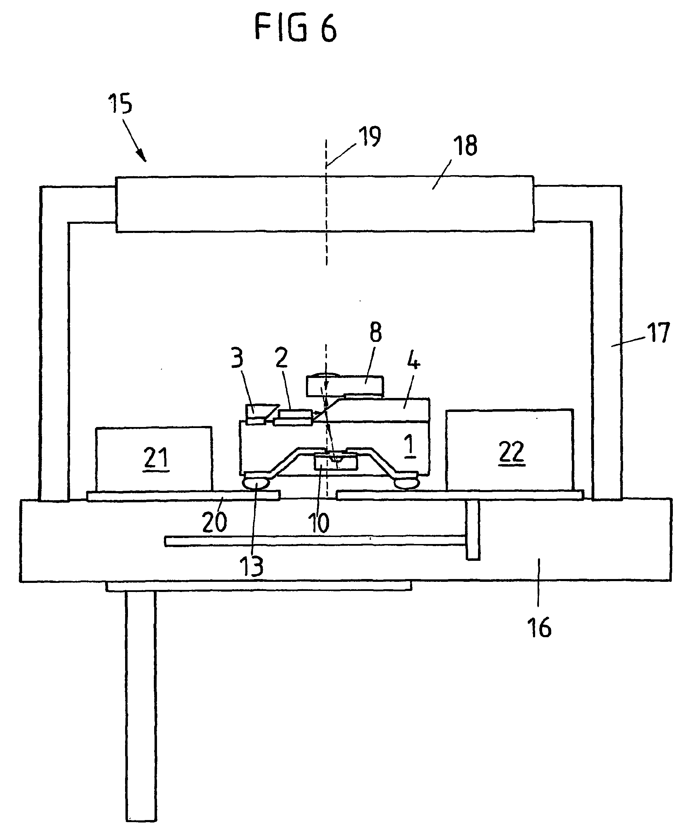

Die Unterseite des Silizium-Submounts 1 weist eine Aussparung 9 auf, die mikromechanisch durch Ätzen in den Siliziumträger 1 eingebracht ist. In der Aussparung 9 befindet sich eine Fotodiode 10 mit einer fotosensitiven Fläche 110. Ein p-Kontakt 120 und ein n-Kontakt 130 sind auf der gleichen Seite der Fotodiode 10 angeordnet, so dass eine Flip-Chip-Montage der Fotodiode 10 auf Metallisierungen 11, 12 an den Wänden der Aussparung 9 erfolgen kann. Auf der Unterseite 102 des Submounts 1 sind auf den Metallisierungen 11, 12 Lötbumps 13 angeordnet, die einer SMD-Montage des gesamten Moduls beispielsweise auf einem Keramikboard dienen, wie in Bezug auf die Figur 6 noch erläutert werden wird.

Die Figur 2 zeigt einen Siliziumwafer 1' mit an dessen Oberseite befestigten Glasprismen 4' und den Metallisierungen 5a, 5b, 7, 12, 12 vor der Vereinzelung. Die Vereinzelung erfolgt entlang der Schnittlinien A. Bevorzugt wird eine Vereinzelung dabei erst dann vorgenommen, wenn die in Figur 1 erläuterten Bauelemente auf dem Siliziumwafer 1' bzw. den jeweiligen Glasprismen 4' angeordnet sind, so dass eine Prüfung der einzelnen Module auf dem Wafer vor der Vereinzelung stattfinden kann.

Die Figur 3 zeigt deutlicher die einzelnen Metallisierungen, Filter und Spiegel, die auf dem Submount 1 und dem Glasprisma 4 vorgesehen sind. Danach ist auf dem Bereich des Submounts 1, auf dem die Laserdiode 2 und die Monitordiode 3 montiert werden, zunächst eine Oxidschicht 51 (z.B. SiO₂), darüber eine Nitridschicht (52 z.B. Si3N4) und daran anschließend jeweils eine Metallisierung 53a, 53b (z.B. TiPtAu) angebracht. Auf der schräg verlaufenden Grenzfläche 41 des Glasprismas 4 ist der wellenlängenselektiver Spiegel 42 (WDM-Spiegel) angeordnet, der das von der Laserdiode 2 ausgesandte Licht reflektiert und von der Fotodiode 10 zu detektierendes Licht durchlässt. Auf der Oberseite des Glasprismas 4 befindet sich die Metallisierungsschicht 7 (z.B. CrPtAu oder TiPtAu) zur Befestigung des Siliziumelements 8 mit der Linse 81.

Die Unterseite des Submounts 1 weist zunächst mittig in der Aussparung 9 einen wellenlängenselektiven Filter (Blockingfilter) 14 auf, der für Licht der Sendediode 2 nicht durchlässig ist und dieses dementsprechend von der Fotodiode 10 abblockt.

Bei dem Blockingfilter 14 handelt es sich bevorzugt entweder um einen Hochpassfilter oder einen Tiefpassfilter. Wird das bidirektionale Modul dabei so ausgelegt, dass der Laser 2 im Fenster zwischen 1260 und 1360 nm sendet und die in der Aussparung 9 angeordnete Fotodiode 10 Licht einer Wellenlänge im Fenster von 1480 bis 1600 nm detektiert, so würde in diesem Fall der Blockingfilter 14 als Hochpassfilter ausgeführt, der die tieferen Wellenlängen von 1260 nm bis 1360 nm blockiert und Wellenlängen ab 1480 nm passieren lässt. Bei einem bidirektionalen Modul auf der Gegenseite, das dann mit 1480 bis 1600 nm sendet und mit 1260 bis 1300 nm empfängt, ist in entsprechender Weise ein Tiefpassfilter vorgesehen.

Auf der Unterseite des Submounts 1 sind des Weiteren wiederum eine Oxidschicht 111, 121, eine Nitrid-Schicht 112, 122 und eine Metallisierung 113, 123 ausgebildet, die sich entlang der Wandung der Aussparung 9 erstrecken. Der Untenansicht der Figur 4 ist zu entnehmen, dass die Metallisierung in der Aussparung 9 derart ausgelegt ist, dass die eine Kontaktfläche 12 für den p-Kontakt eine möglichst kleine Fläche aufweist, um die elektrische Kapazität der Empfangseinheit gering zu halten. Die zweite Kontaktfläche 11 für n-Kontakt ist dagegen möglichst großflächig ausgelegt, um eine gute Wärmeleitfähigkeit zu gewährleisten. Diese Wärmeleitfähigkeit ist notwendig, um die von dem Laserchip 2 erzeugte Wärme, die in das Siliziumsubstrat 1 ausstrahlt, gut vom Siliziumsubstrat 1 ableiten zu können.

Ebenfalls dargestellt in Figur 4 sind die auf der Unterseite des Submounts 1 angeordnete Lötbumps 13, die der weiteren Montage des Moduls auf einem Träger dienen. Statt Lötbumps ist dabei auch eine Klebung möglich.

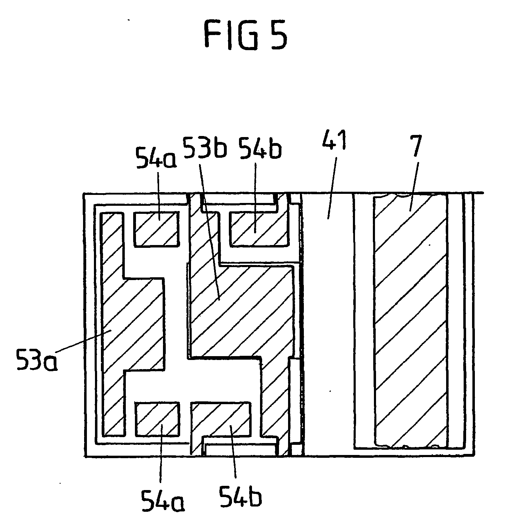

Die Figur 5 zeigt eine Draufsicht auf die Oberseite von Submount 1 und Glasprisma 4. Es sind die Lötfläche bzw. Metallisierung 53a für die Monitordiode 3 und die Lötfläche bzw. Metallisierung 53b für die Laserdiode 2 zu erkennen. Weitere Metallisierungen 54a, 54b dienen der Montage der Bonddrähte 6. Hinsichtlich des Glasprismas sind die unter einem Winkel von 45° verlaufende Schräge 41 und die Metallisierung 7 für das Siliziumteil mit der Linse 81 zu erkennen.

Die Funktion des beschriebenen Sende- und Empfangsmoduls ist wie folgt. Von der Laserdiode 2 ausgesandtes Licht einer ersten Wellenlänge wird an dem wellenlängenselektiven Spiegel 42 der unter einem Winkel von 45° verlaufenden Grenzfläche 41 des Glasprismas 4 reflektiert und senkrecht zur Oberfläche 101 des Submounts abgestrahlt. Das reflektierte Laserlicht durchtritt dabei die oberhalb der Schräge 41 angeordnete Linse 81 und wird anschließend in eine Lichtleitfaser angekoppelt. Aus der entsprechenden Lichtleitfaser ausgekoppeltes Licht einer zweiten Wellenlänge, das in entgegengesetzter Richtung verläuft und durch die Fotodiode 10 zu detektieren ist, fällt durch die Linse 81 auf die Schräge 41 des Glasprismas. Da der wellenlängenselektive Spiegel 42 für die Empfangswellenlänge durchlässig ist, wird das zu empfangende Licht in das Glasprisma 4 gebrochen.

Die Lichtbrechung erfolgt dabei aufgrund des Umstandes, dass das Glasprisma 4 einen höheren Brechungsindex als Luft aufweist, zum Lot hin. Das zu empfangende Licht durchquert nun das Glasprisma 4 und tritt anschließend in das Silizium-Submount 1 ein, das für die betrachteten Wellenlängen (oberhalb 1000 nm) transparent ist. Das Glasprisma 4 ist dabei beispielsweise durch anodisches Bonden mit dem Silizium-Submount 1 verbunden, wobei sich in der Grenzschicht des Glasprismas 4 zum Siliziumträger 1 durch eindiffundierte Ionen der Brechungsindex des Glases erhöht und an der Grenzfläche gleich dem Brechungsindex des angrenzenden Siliziumträgers 1 ist, so dass das Licht beim Übergang zwischen dem Glasprisma 4 und dem Siliziumtärger 1 nicht gebrochen wird.

Das zu empfangende Licht durchquert nun den Siliziumträger 1 und tritt an der Unterseite im Bereich der Aussparung 9 aus dem Siliziumträger 1 aus. Die Fotodiode 10 ist derart in der Aussparung 9 angeordnet, dass die fotosensitive Fläche 110 mit dem zu empfangenden Licht bestrahlt wird. Vor einer Detektion durchläuft das zu detektierende Licht den Blockingfilter 14, so dass eventuell vorhandenes Streulicht der Fotodiode 2 ausgekoppelt wird.

Es wird darauf hingewiesen, dass das zu empfangende Licht aufgrund des Brechungsindexes des Glasprismas 4 derart in das Glasprisma und anschließend in das Silizium-Submount eingekoppelt wird, dass es an der Unterseite des Silizium-Submounts 1 keine Totalreflexion erfährt und dementsprechend durch die Fotodiode 10 detektiert werden kann. Durch den Brechungsindex des Glasprismas 4 ergibt sich somit ein Strahlengang, der ein Austreten des Lichtes aus der planen Unterseite 101 des Silizium-Submounts 1 ermöglicht.

Die Figur 6 zeigt das zuvor beschriebene Sende- und Empfangsmodul in der Anordnung in einem Gehäuse 15. Das Gehäuse 15 weist eine mehrlagige Bodenplatte 16 aus Keramik, eine Kappe 17 und ein planes Glasfenster 18 auf. Das plane Glasfenster 18 stellt eine Lichteintritts-/Austrittsöffnung des Gehäuses dar, an das in an sich bekannter Weise entlang der Achse 19 eine Lichtleitfaser angekoppelt wird. Das von der Sendediode 2 ausgesandte Licht wird dabei in eine solche Glasfaser eingekoppelt. Gleichzeitig wid aus der Glasfaser Licht ausgekoppelt, das an dem anderen Ende einer optischen Verbindung durch ein entsprechend aufgebautes Sende- und Empfangsmodul ausgesandt wurde. Dieses ausgekoppelte Licht wird wie beschrieben durch die Empfangsdiode 10 detektiert. Das Sende- und Empfangsmodul ist mittels der Lötbumps 13 auf Metallisierungen 20 der Bodenplatte angeordnet.

Die Bodenplatte 16 trägt des weiteren einen Transimpedanzverstärker 21 zur Vorverstärkung der durch die Fotodiode 10 detektierten Signale und SMD-Kondensatoren 22.

Es wird insgesamt eine hochkompakte Anordnung bereitgestellt, bei der die Sendediode 2 und die Empfangsdiode 10 auf einem gemeinsamen Träger angeordnet sind und dieser Träger sich in nur einem Gehäuse befindet, in das über eine optische Ankopplung Licht ein- bzw. ausgekoppelt wird.

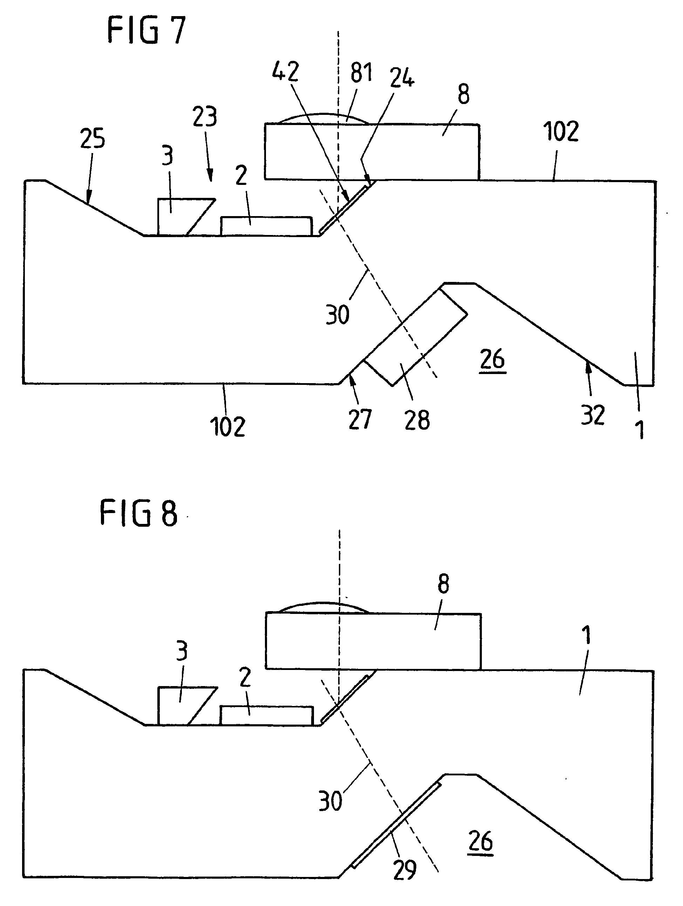

Die Figuren 7 bis 10 zeigen ein zweites Ausführungsbeispiel eines bidirektionalen Sende- und Empfangsmoduls. Gleiche Bezugszeichen kennzeichnen dabei entsprechende Bauteile. Es wird die Ausführungsform der Figuren 7 bis 10 nur insofern erläutert, als Unterschiede zu dem Ausführungsbeispiel der Figuren 1 bis 6 bestehen.

Der wesentliche Unterschied besteht darin, dass das Ausführungsbeispiel der Figuren 7 bis 9 ohne ein Glasprisma auskommt. Stattdessen ist die schräg verlaufende Grenzfläche mit dem wellenlängenselektiven Spiegel 42 an dem Träger 1 selbst ausgebildet. Hierzu weist der Siliziumträger 1 an seiner Oberseite 101 eine Aussparung 23 auf, die die Form eines Grabens oder einer Grube besitzt und die durch Ätzen des Siliziumsubstrats 1 hergestellt ist. Die Aussparung 23 bildet zwei gegenüberliegende Schrägen 24, 25 aus. Die rechte, der Laserdiode 2 zugeordnete Schräge 24 ist unter einem Winkel von 45° geätzt und entspricht in ihrer Funktion der Grenzfläche 41 des Glasprismas 4 der Figuren 1 bis 6. Der wellenlängenselektive Spiegel 24 ist auf der Schräge 24 angeordnet.

Die gegenüberliegende Schräge 25 weist 63° als schrägen Winkel auf, was sich aus der Kristallorientierung des Siliziums ergibt. In einer Weiterbildung des dargestellten Ausführungsbeispiels kann die 63°-Schräge 25 als Strahlumlenkungseinheit für die rückseitige Strahlung des Lasers dienen, wobei dann oberhalb der Schräge 25 auf der Oberfläche 101 des Trägers eine Monitordiode montiert ist. Die Monitordiode würde also in dieser Ausgestaltung anders als in der dargestellten Ausgestaltung nicht in der Aussparung 23 angeordnet sein. Dies kann insbesondere dann sinnvoll sein, wenn die Aussparung relativ klein ist.

Das Siliziumelement 8 mit der Linse 1 ist direkt auf dem Träger 1 angeordnet.

Auch auf der Unterseite 102 des Siliziumträgers 1 ist wiederum eine Aussparung 26 ausgebildet. Diese Aussparung weist ebenfalls zwei Schrägen 27, 32 auf. Die linke Schräge 27 ist ebenfalls unter einem Winkel von 45° durch Ätzen in das Siliziumsubstrat eingebracht. Dementsprechend liegen die beiden 45°-Flächen 24, 27 auf der Ober- und Unterseite des Substrats 1 in parallelen Ebenen. Grundsätzlich muss dies jedoch nicht der Fall sein und können die Ausrichtungen dieser beiden Ebenen 24, 27 auch voneinander abweichen. Dabei ist zu beachten, dass insbesondere die Aussparung 27 statt durch Ätzen auch durch Sägen bzw. Trennschleifen erzeugt werden kann, so dass eine größere Wahlfreiheit hinsichtlich des Winkels der Schräge 27 besteht.

An der Schräge 27 ist im Lichtaustrittsbereich ein Glas- oder Siliziumplättchen 28 montiert, das mit einem Blockingfilter versehen ist, der entsprechend den obigen Ausführungen bevorzugt als Hochpassfilter oder Tiefpassfilter ausgebildet ist. Sofern die Aussparung 26 durch Sägen oder Trennschleifen erzeugt ist, kann das Plättchen 24 mittels eines transparenten Klebers aufgeklebt sein. Dabei ist der Kleber bevorzugt indexangepasst, so dass er die Funktion einer Immersionsflüssigkeit bzw. eines Matchinggels übernimmt, so dass der Einfluss der Sägerauhigkeit auf die Strahlung minimiert wird.

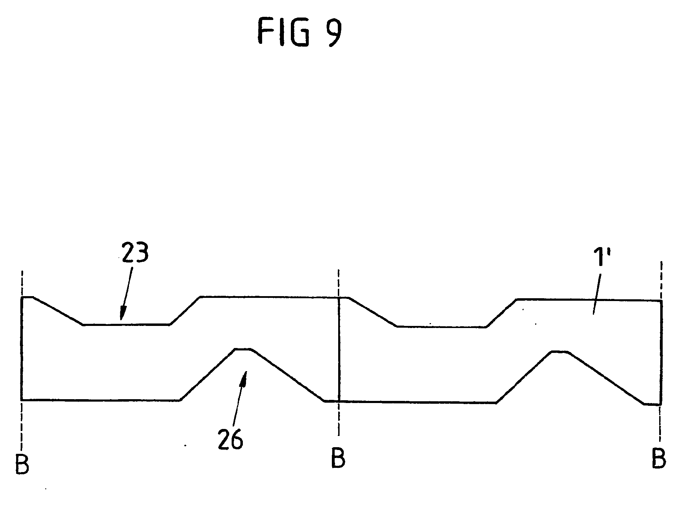

In dem Ausführungsbeispiel der Figur 8 wird kein gesondertes Glas- oder Siliziumplättchen 24 verwendet und ist der Blockingfilter 29 stattdessen unmittelbar auf die Schräge 27 der Aussparung 26 aufgebracht.

Die Figur 9 zeigt eine Schnittdarstellung des Siliziumwafers 1' vor der Vereinzelung entlang Sägelinien B.

Der Strahlengang der Laserdiode 2 entspricht dem Strahlengang des Ausführungsbeispiels der Figuren 1 bis 6. Für die empfangene Strahlung ergibt sich aufgrund des höheren Brechungsindex von Silizium gegenüber Glas dagegen ein anderer Strahlengang 30. Die zu empfangende Strahlung wird aufgrund des höheren Brechungsindexes stärker zum Lot der Grenzfläche 24 gebrochen, so dass die zu empfangende Strahlung einen schrägeren Verlauf im Siliziumsubstrat 1 nimmt. Dies würde dazu führen, dass die Strahlung, sofern keine Aussparung 26 vorgesehen wäre, unter einem Winkel auf die plane Unterseite 102 des Trägers 1 fallen würde, der größer ist als der Winkel der Totalreflexion. Die Strahlung könnte dann gar nicht aus dem Siliziumträger austreten.

Daher ist die Aussparung 26 mit der Schräge 27 in das Siliziumsubstrat 1 eingebracht. Das zu empfangende Licht tritt durch die Schräge 27 aus dem Siliziumsubstrat aus, wobei aufgrund der winkligen Anordnung der Schräge 27 das Licht austreten kann und keine Totalreflexion erfährt.

Die stärkere Brechung des zu empfangenden Lichtes im Siliziumsubstrat wird somit durch Bereitstellen einer Schräge an der Unterseite des Trägers ausgeglichen, aus der das zu empfangende Licht austritt. Die durch die Aussparung 26 bereitgestellte Lichtaustrittsebene 27 ist so ausgelegt, dass der Grenzwinkel der Totalreflexion im Silizium bei den betrachteten Wellenlängen zwischen 1260 und 600 nm nicht auftritt, wenn die Strahlung über den 45° Strahlteiler 24 in den Siliziumträger 1 eintritt.

Die Herstellung des beschriebenen Trägers erfolgt beispielsweise durch Ätzen eines entsprechenden Siliziumwafers auf der Ober- und Unterseite, einem anschließenden Anbringen der Metallisierungen, Filter und Spiegel sowie der beschriebenen Komponenten. Eine Vorprüfung erfolgt dabei bevorzugt vor der Vereinzelung. Es ist jedoch ebenso möglich, zwei Siliziumwafer unabhängig voneinander jeweils mit der Struktur der Oberseite 101 und der Struktur der Unterseite 102 zu strukturieren und die beiden Wafer anschließend mittels Waferfusing miteinander zu verbinden. Die weitere Herstellung erfolgt dann wie zuvor beschrieben.

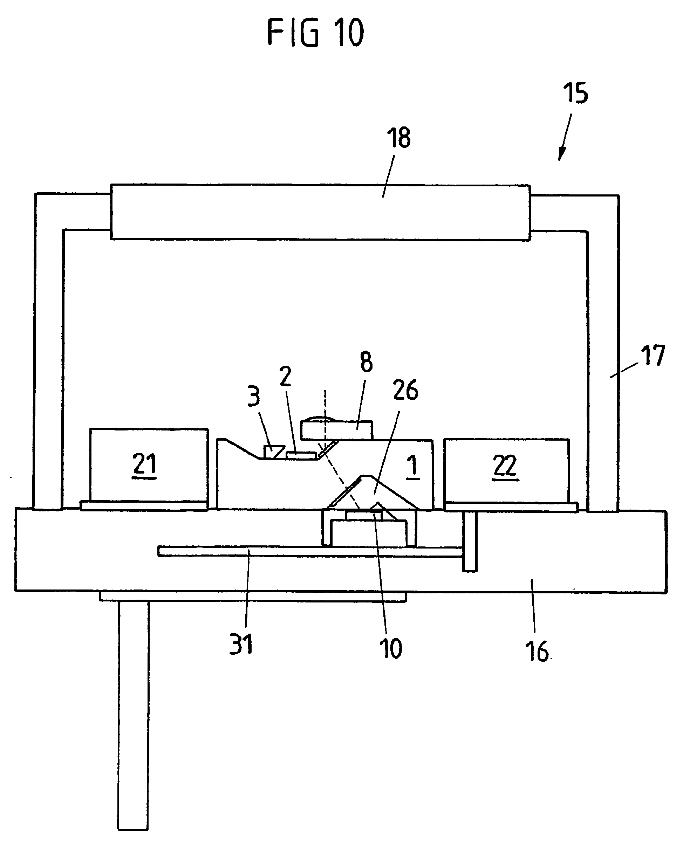

Die Figur 10 schließlich zeigt die Anordnung des bidirektionalen Sende- und Empfangsmoduls in einem Gehäuse 15, das entsprechend dem Gehäuse 15 der Figur 6 ausgebildet ist. Allerdings ist die Fotodiode 10 hier nicht unmittelbar an der Unterseite des Siliziumträgers 1 angeordnet. Sie befindet sich jedoch unterhalb des Siliziumträgers 1 in einer Position, dass das aus der Schräge 27 aus dem Träger 1 ausgetretene Licht auf die lichtsensitive Fläche der Fotodiode fällt. Die Fotodiode ist über eine Metallisierung 31 mit mehrlagigen Bodenplatte 16 kontaktiert.

In einer alternativen Ausgestaltung kann jedoch auch vorgesehen sein, dass die Monitordiode unmittelbar an der Lichtaustrittsfläche bzw. Schräge 27 des Trägersubstrats 1 angeordnet ist. Eine solche Ausgestaltung ist insbesondere bei kleinflächigen Fotodioden und/oder relativ großen Aussparungen 26 an der Unterseite des Siliziumträgers 1 sinnvoll.

## Patentansprüche

1. Bidirektionales Sende- und Empfangsmodul mit einem Träger (1) mit einer Oberseite (101) und einer Unterseite (102),
- einem an der Oberseite des Trägers (1) angeordneten Sendebauelement (2), das Licht einer ersten Wellenlänge aussendet,
- einem an der Unterseite des Trägers (1) angeordneten Empfangsbauelement (10), das Licht einer zweiten Wellenlänge empfängt, wobei der Träger (1) für das Licht der zweiten Wellenlänge transparent ist, und
- einer schräg verlaufenden, mit einem wellenlängenselektiven Spiegel (42) beschichteten Grenzfläche (41, 24), an der vom Sendebauelement (2) ausgesandtes Licht reflektiert und umgelenkt und an der vom Empfangsbauelement (10) zu empfangendes Licht in das angrenzende Medium (4, 1) gebrochen wird, wobei
- das zu empfangende, an der Grenzfläche (41, 24) gebrochene Licht den Träger (1) durchquert, an der Unterseite des Trägers (1) aus diesem austreten kann und durch das Empfangsbauelement (10) detektiert wird, **dadurch gekennzeichnet, dass**
- die Unterseite (102) des Trägers (1) eine Aussparung (9) mit ausreichender Tiefe aufweist, um das darin angeordnete Empfangsbauelement (10) vollständig aufzunehmen.

2. Modul nach Anspruch 1, **gekennzeichnet durch** einen Zusatzkörper (4), insbesondere ein Glasprisma, der auf dem Träger (1) angeordnet ist und der die schräg verlaufende Grenzfläche (41) mit dem wellenselektiven Spiegel (42) ausbildet, wobei das zu empfangende, an der Grenzfläche (41) gebrochene Licht zunächst den Zusatzkörper (4) und dann den Träger (1) durchquert.

3. Modul nach Anspruch 2, **dadurch gekennzeichnet, dass** der Zusatzkörper (4) und der Träger (1) durch anodisches Bonden miteinander verbunden sind.

4. Modul nach Anspruch 2 oder 3, **dadurch gekennzeichnet, dass** der Zusatzkörper (4) derart ausgelegt ist, dass das zu empfangende Licht nach Durchqueren des Träger (1) keine Totalreflexion an der Unterseite des Trägers (1) erfährt und durch das Empfangsbauelement (10) detektierbar ist.

5. Modul nach mindestens einem der Ansprüche 2 bis 4, **dadurch gekennzeichnet, dass** dem Empfangsbauelement (10) ein wellenlängenselektiver Filter (14) zugeordnet ist, der sich an der Unterseite der Trägers (1) befindet und die Transmission von Licht der ersten Wellenlänge blockiert.

6. Modul nach Anspruch 5, **dadurch gekennzeichnet, dass** der wellenlängenselektive Filter (15) ein Hochpassfilter oder ein Tiefpassfilter ist.

7. Modul nach mindestens einem der Ansprüche 2 bis 6, **dadurch gekennzeichnet, dass** die Aussparung (9) des Trägers (1) mit Metallisierungen (11, 12) versehen ist und das Empfangsbauelement (10) in Flip-Chip Montage in der Aussparung (9) montiert ist.

8. Modul nach Anspruch 5, **dadurch gekennzeichnet, dass** die Metallisierungen eine p-Kontaktfläche (12) und eine n-kontaktfläche (11) zur Kontaktierung des Empfangsbauelements (10) aufweisen, wobei die eine der Kontaktflächen (12) eine vergleichsweise geringe Fläche aufweist und die andere der Kontaktflächen (11) großflächig ausgelegt ist.

9. Modul nach mindestens einem der Ansprüche 2 bis 8, **dadurch gekennzeichnet, dass** der Zusatzkörper (4) Träger einer strahlformenden Optik (8, 81), insbesondere einer fokussierenden Linse ist, die das ausgesandte und empfangene Licht vor bzw. nach der Ein- bzw. Auskopplung in ein bzw. aus einem an das Modul ankoppelbaren Lichtwellenleiter durchstrahlt, wobei die strahlformende Optik (8, 81) oberhalb der schräg verlaufenden Grenzfläche (41) des Zusatzkörpers (4) angeordnet ist.

10. Modul nach Anspruch 1, **dadurch gekennzeichnet, dass** die schräg verlaufende Grenzfläche (24) an dem Träger (1) selbst ausgebildet ist.

11. Modul nach Anspruch 10, **dadurch gekennzeichnet, dass** die schräg verlaufende Grenzfläche (24) an der Schräge einer Aussparung (23) an der Oberseite (101) des Trägers (1) ausgebildet ist, wobei das Sendebauelement (2) in der Aussparung (23) angeordnet ist.

12. Modul nach Anspruch 11, **dadurch gekennzeichnet, dass** eine andere, gegenüberliegende Schräge (25) der Aussparung als Strahlumlenkungseinheit für eine dem Sendebauelement (2) zugeordnete Monitordiode dient, wobei die Monitordiode auf der obersten Ebene der Oberseite (101) des Trägers (1) angeordnet ist.

13. Modul nach mindestens einem der Ansprüche 10 bis 12, **dadurch gekennzeichnet, dass** die Unterseite des Trägers (1) zumindest in einem Teilbereich (27) derart in Bezug auf die Ausbreitungsrichtung des zu empfangenden Lichts im Träger orientiert ist, dass das zu empfangende Licht nach Durchqueren des Trägers (1) keine Totalreflexion erfährt und durch das Empfangsbauelement: (10) detektiert werden kann.

14. Modul nach Anspruch 13, **dadurch gekennzeichnet, dass** der Träger (1) auf seiner Unterseite eine Aussparung (26) mit einer Schräge (27) aufweist, aus der das zu empfangende Licht austritt.

15. Modul nach Anspruch 14, **dadurch gekennzeichnet, dass** die Schräge (27) als Träger eines wellenlängenselektiven Filters (29) dient, der die Transmission von Licht der ersten Wellenlänge blockiert.

16. Modul nach Anspruch 15, **dadurch gekennzeichnet, dass** der wellenlängenselektive Filter an einem gesonderten Träger (28) ausgebildet ist, der bevorzugt mittels eines indexangepassten, transparenten Klebers an der Schräge (27) befestigt ist.

17. Modul nach Anspruch 14, **dadurch gekennzeichnet, dass** das Empfangsbauelement an der Schräge (27) angeordnet ist.

18. Modul nach Anspruch 14, **dadurch gekennzeichnet, dass** die Schräge (27) der Aussparung (26) an der Unterseite (102) des Trägers (1) parallel verläuft zu der schräg verlaufenden Grenzfläche (24) an der Oberseite (101) des Trägers (1), wobei beide Schrägen (27, 24) bevorzugt unter einem Winkel von 45° zur Montagefläche des Sendebauelements (2) verlaufen.

19. Modul nach mindestens einem der Ansprüche 10 bis 18, **dadurch gekennzeichnet, dass** die Oberseite des Trägers aus einem ersten strukturierten Wafer und die Unterseite des Trägers aus einem zweiten strukturierten Wafer gebildet ist, die nach der Strukturierung mittels Waferfusing miteinander verbunden sind.

20. Modul nach mindestens einem der Ansprüche 10 bis 19, **dadurch gekennzeichnet, dass** an dem Träger (1) angrenzend an die schräg verlaufende Grenzfläche (24) eine strahlformenden Optik (8, 81), insbesondere eine fokussierende Linse angebracht ist, die das ausgesandte und empfangene Licht vor bzw. nach der Ein- bzw. Auskopplung in ein bzw. aus einem an das Modul ankoppelbaren Lichtwellenleiter durchstrahlt, wobei die strahlformende Optik oberhalb der schräg verlaufenden Grenzfläche (24) angeordnet ist.

21. Modul nach mindestens einem der Ansprüche vorangehenden Ansprüche, **dadurch gekennzeichnet, dass** der Träger (1) aus Silizium besteht.

22. Modul nach mindestens einem der Ansprüche vorangehenden Ansprüche, **dadurch gekennzeichnet, dass** schräg verlaufende Grenzfläche (41, 24) unter einem Winkel von 45° zur Ebene der Oberseite (101) des Träger (1) verläuft.

23. Modul nach mindestens einem der Ansprüche vorangehenden Ansprüche, **dadurch gekennzeichnet, dass** das Sendebauelement (2) eine seitlich emittierende Laserdiode ist, deren Strahlung unmittelbar auf die schräg verlaufende Grenzfläche (41, 24) fällt.

24. Modul nach mindestens einem der Ansprüche vorangehenden Ansprüche, **gekennzeichnet durch** ein Gehäuse (15), in dem der Träger (1) mit den darauf montierten Komponenten angeordnet ist, wobei das Gehäuse (15) eine mit Metallisierungen versehene mehrlagige keramische Bodenplatte (16) und eine mit einem Lichteintritts/austrittsfensfenster (18) versehene Kappe (17) aufweist.

## Claims

1. Bi-directional transmitting and receiving module with
- a support (1) with a top side (101) and an underneath side (102)
- a structural transmitting element (2) mounted on the top side of the support (1) and emitting light of a first wavelength
- a structural receiving element (10) mounted on the underneath side of the support (1) and receiving light of a second wavelength, wherein the support (1) is transparent for the light of the second wavelength, and
- an inclined boundary surface (41, 24) coated with a wavelength-selective reflector (42) where the light emitted from the transmitting element (2) is reflected and diverted and where the light to be received from the receiving element (10) is refracted into the adjoining medium (4,1) wherein
- the light which is to be received and is refracted at the boundary surface (41, 24) crosses through the support (1), can emerge from the support (1) at the underneath side thereof and is detected through the receiving element (10),
**characterised in that**
- the underneath side (102) of the support (1) has a recess (9) of sufficient depth to accommodate completely the receiving element (10) which is mounted therein.

2. Module according to claim 1, **characterised by** an additional body (4), more particularly a glass prism, which is mounted on the support (1) and which forms the inclined boundary face (41) with the wave-selective reflector (42) whereby the light which is to be received and is refracted at the boundary face (41) first crosses through the additional body (4) and then the support (1).

3. Module according to claim 2, **characterised in that** the additional body (4) and the support (1) are connected to one another through anodic bonding.

4. Module according to claim 2 or 3, **characterised in that** the additional body (4) is designed so that the light which is to be received, after crossing through the support (1), experiences no total reflection on the underneath side of the support (1) and can be detected through the receiving element (10).

5. Module according to at least one of claims 2 to 4, **characterised in that** the receiving element (10) is assigned a wavelength-selective filter (14) which is located on the underneath side of the support (1) and blocks the transmission of light of the first wavelength.

6. Module according to claim 5, **characterised in that** the wavelength-selective filter (15) is a high pass filter or a low pass filter.

7. Module according to at least one of claims 2 to 6, **characterised in that** the recess (9) of the support (1) is provided with metal plating (11, 12) and the receiving element (10) is mounted in flip-chip assembly in the recess (9).

8. Module according to claim 5, **characterised in that** the metal platings have a p-contact face (12) and an n-contact face (11) for contacting the receiving element (10), wherein the one of the contact faces (12) has a comparatively small surface area and the other of the contact faces (11) has a large surface area.

9. Module according to at least one of claims 2 to 8, **characterised in that** the additional body (4) is a support of a ray-forming optic (8, 81) more particularly a focusing lens which the emitted and received light radiates through before and after the coupling and disconnection in and out of a light wave conductor which can be coupled onto the module, wherein the ray-forming optic (8, 81) is mounted above the inclined boundary face (41) of the additional body (4).

10. Module according to claim 1, **characterised in that** the inclined boundary face (24) is formed on the support (1) itself.

11. Module according to claim 10, **characterised in that** the inclined boundary face (24) is formed in the incline of a recess (23) on the top side (101) of the support (1) wherein the transmitting element (2) is mounted in the recess (23).

12. Module according to claim 11, **characterised in that** another opposing incline (25) of the recess serves as the ray deflection unit for a monitor diode assigned to the transmitting element (2) wherein the monitor diode is mounted on the topmost plane of the top side (101) of the support (1),

13. Module according to at least one of claims 10 to 12, **characterised in that** the underneath side of the support (1) is aligned at least in a partial area (27) in relation to the propagation direction of the light to be received in the support so that the light which is to be received after crossing through the support (1) experiences no total reflection and can be detected through the receiving element (10).

14. Module according to claim 13, **characterised in that** the support (1) has on its underneath side a recess (26) with an incline (27) from which the light which is to be received emerges.

15. Module according to claim 14, **characterised in that** the incline (27) serves as a support of a wavelength-selective filter (29) which blocks the transmission of light of the first wave length.

16. Module according to claim 15, **characterised in that** the wavelength-selective filter is formed on a separate support (28) which is preferably fixed on the incline (27) by means of an index-adapted transparent adhesive.

17. Module according to claim 14, **characterised in that** the receiving element is mounted on the incline (27).

18. Module according to claim 14, **characterised in that** the incline (27) of the recess (26) on the underneath side (102) of the support (1) runs parallel to the inclined boundary face (24) on the top side (101) of the support (1) wherein the two inclines (27, 24) preferably run at an angle of 45° to the assembly face of the transmitting element (2).

19. Module according to at least one of claims 10 to 18, **characterised in that** the top side of the support comprises a first structured wafer and the underneath side of the support comprises a second structured wafer which are connected to one another after structuring by means of wafer fusing.

20. Module according to at least one of claims 10 to 19, **characterised in that** a ray forming optic (8, 81), more particularly a focussing lens, is attached to the support (1) adjoining the inclined boundary face (24), which the emitted and received light radiates through before and after coupling in and disconnection from a lightwave conductor which can be coupled to the module whereby the ray-forming optic is mounted above the inclined boundary face (24).

21. Module according to at last one of the preceding claims, **characterised in that** the support (1) is made of silicon.

22. Module according to at least one of the preceding claims, **characterised in that** the inclined boundary face (41, 24) runs at an angle of 45° to the plane of the top side (101) of the support (1).

23. Module according to at least one of the preceding claims, **characterised in that** the transmitting element (2) is a laterally emitting laser diode whose beam falls directly on the inclined boundary face (41, 24).

24. Module according to at least one of the preceding claims, **characterised by** a housing (15) in which the support (1) is mounted with the components fitted thereon, wherein the housing (15) has a multi-layer ceramic base plate (16) with metal plating, as well as a cap (17) which is provided with a light inlet/outlet window (18).

## Revendications

1. Module d'émission et de réception bidirectionnel comprenant
un support (1) avec une face supérieure (101) et une face inférieure (102),
un élément d'émission (2) disposé au niveau de la partie supérieure du support (1), qui émet de la lumière à une première longueur d'onde,
un élément de réception (10) disposé au niveau de la partie inférieure du support (1), qui reçoit de la lumière à une seconde longueur d'onde, moyennant quoi le support (1) est transparent pour la lumière de la seconde longueur d'onde, et
une surface de séparation (41, 24) recouverte d'un miroir (42) sélectif de longueur d'onde incliné, au niveau duquel la lumière émise par l'élément d'émission (2) est réfléchie et déviée et au niveau duquel la lumière qui doit être reçue par l'élément de réception (10) est brisée dans le milieu (4, 1) de séparation, moyennant quoi la lumière séparée au niveau de la surface de séparation (41, 24) et qui doit être reçue traverse le support (1), peut sortir de celui-ci au niveau de la face inférieure du support (1) et est détectée par l'élément de réception (10), **caractérisé en ce que**
la face inférieure (102) du support (1) comporte un évidement (9) avec une profondeur suffisante pour contenir entièrement l'élément de réception (10) disposé sur celui-ci.

2. Module selon la revendication 1, **caractérisé par** un corps supplémentaire (4), plus particulièrement un prisme de verre, qui est placé sur le support (1) et forme la surface de séparation (41) inclinée avec le miroir (42) sélectif des ondes, moyennant quoi la lumière séparée au niveau de la surface de séparation (41) qui doit être reçue traverse tout d'abord le corps supplémentaire (4) puis le support (1).

3. Module selon la revendication 2, **caractérisé en ce que** le corps supplémentaire (4) et le support (1) sont reliés l'un à l'autre par une métallisation anodique.

4. Module selon la revendication 2 ou 3, **caractérisé en ce que** le corps supplémentaire (4) est prévu de sorte que la lumière à recevoir ne subit aucune réflexion totale après avoir traversé le support (1) au niveau de la face inférieure du support (1), et **en ce que** l'élément de réception (10) peut être détecté.

5. Module selon au moins l'une quelconque des revendications 2 à 4, **caractérisé en ce qu'**un filtre sélectif de longueur d'onde (14) est affecté à l'élément de réception (10), lequel filtre se situe au niveau de la face inférieure du support (1) et bloque la transmission de la lumière de la première longueur d'onde.

6. Module selon la revendication 5, **caractérisé en ce que** le filtre sélectif de longueur d'onde (15) est un filtre passe-haut ou un filtre passe-bas.

7. Module selon au moins l'une quelconque des revendications 2 à 6, **caractérisé en ce que** l'évidement (9) du support (1) est pourvu de métallisations (11, 12) et **en ce que** l'élément de réception (10) est installé dans l'évidement (9) par connexion à billes.

8. Module selon la revendication 5, **caractérisé en ce que** les métallisations comportent une surface de contact de type p (12) et une surface de contact de type n (11) pour établir le contact de l'élément de réception (10), moyennant quoi une des surfaces de contact (12) comporte une petite surface similaire et l'autre surface de contact (11) est prévue avec une grande surface.

9. Module selon au moins l'une quelconque des revendications 2 à 8, **caractérisé en ce que** le corps supplémentaire (4) du support est un instrument optique de focalisation (8, 81), plus particulièrement une lentille de mise au point, qui transmet la lumière émise et reçue avant ou après le déclenchement ou l'injection dans ou en dehors d'un guide d'ondes optiques pouvant être couplé, moyennant quoi l'instrument optique de focalisation (8, 81) est placé au-dessus de la surface de séparation (41) inclinée du corps supplémentaire (4).

10. Module selon la revendication 1, **caractérisé en ce que** la surface de séparation (24) inclinée est formée sur le support (1) lui-même.

11. Module selon la revendication 10, **caractérisé en ce que** la surface de séparation (24) inclinée est formée au niveau de l'inclinaison d'un évidement (23) au niveau de la face supérieure (101) du support (1), moyennant quoi l'élément d'émission (2) est disposé dans l'évidement (23).

12. Module selon la revendication 11, **caractérisé en ce qu'**une autre inclinaison (25) opposée à l'évidement sert d'unité de déviation des rayons pour une diode de contrôle affectée à l'élément d'émission (2), moyennant quoi la diode de contrôle est placée au niveau le plus haut de la face supérieure (101) du support (1).

13. Module selon au moins l'une quelconque des revendications 10 à 12, **caractérisé en ce que** la face inférieure du support (1) est orientée au moins dans une zone partielle (27) en référence au sens de propagation de la lumière à recevoir dans le support, de sorte que la lumière à recevoir ne subit aucune réflexion totale une fois le support (1) traversé et **en ce que** l'élément de réception (10) peut être détecté.

14. Module selon la revendication 13, **caractérisé en ce que** le support (1) comporte un évidement (26) sur sa face inférieure avec une inclinaison (27), par lequel sort la lumière à recevoir.

15. Module selon la revendication 14, **caractérisé en ce que** l'inclinaison (27) sert de support d'un filtre sélectif de longueur d'onde (29), qui bloque la transmission de la lumière de la première longueur d'onde.

16. Module selon la revendication 15, **caractérisé en ce que** le filtre sélectif de longueur d'onde est conçu au niveau d'un support (28) séparé, qui est fixé à l'inclinaison (27) de préférence au moyen d'une colle transparente adaptée à l'index.

17. Module selon la revendication 14, **caractérisé en ce que** l'élément de réception est placé au niveau de l'inclinaison (27).

18. Module selon la revendication 14, **caractérisé en ce que** l'inclinaison (27) de l'évidement (26) au niveau de la face inférieure (102) du support (1) est parallèle à la surface de séparation (24) inclinée de la face supérieure (101) du support (1), moyennant quoi les deux inclinaisons (27, 24) sont de préférence inclinées d'un angle de 45° par rapport à la surface de montage de l'élément d'émission (2).

19. Module selon au moins l'une quelconque des revendications 10 à 18, **caractérisé en ce que** la face supérieure du support est formée d'une première plaquette de silicium structurée et la face inférieure du support d'une seconde plaquette de silicium structurée, lesquelles sont reliées l'une à l'autre après la structuration au moyen de la fusion des plaquettes.

20. Module selon au moins l'une quelconque des revendications 10 à 19, **caractérisé en ce qu'**un instrument optique de focalisation (8, 81), plus particulièrement une lentille de mise au point, est placé séparément sur le support (1) au niveau de la surface de séparation (24) inclinée, lequel instrument optique radiographie la lumière émise et reçue avant ou après le déclenchement ou l'injection dans ou en dehors d'un guide de longueurs d'ondes pouvant être couplé au module, moyennant quoi l'instrument optique de focalisation est placé au-dessus de la surface de séparation (24) inclinée.

21. Module selon au moins l'une quelconque des revendications précédentes, **caractérisé en ce que** le support (1) est en silicium.

22. Module selon au moins l'une quelconque des revendications précédentes, **caractérisé en ce que** la surface de séparation (41, 24) inclinée forme un angle de 45° par rapport au niveau de la face supérieure (101) du support (1).

23. Module selon au moins l'une quelconque des revendications précédentes, **caractérisé en ce que** l'élément d'émission (2) est une diode laser émettant latéralement, dont le rayonnement tombe directement sur la surface de séparation (41, 24) inclinée.

24. Module selon au moins l'une quelconque des revendications précédentes, **caractérisé par** un logement (15), dans lequel le support (1) est disposé avec les composants installés sur lui, moyennant quoi le logement (15) comporte une plaque de fond (16) en céramique de protection pourvue de métallisations et un cache (17) pourvu d'une fenêtre d'entrée/sortie de la lumière (18).
